# EUROPEAN PATENT APPLICATION

(11) **EP 4 447 130 A1**
(43) Date of publication of application: **16.10.2024**
(21) Application number: 23874249.8
(22) Date of filing: 21.06.2023
(51) Int. Cl.: H01L 31/05, H01L 31/0224

(54) **CONNECTION STRUCTURE FOR BATTERY AND SOLDER STRIPS, AND BATTERY ASSEMBLY COMPRISING CONNECTION STRUCTURE**

(30) Priority: 08.10.2022 CN 202211220767
(71) Applicant: Zhejiang Znergy Solar Co., Ltd., Hangzhou, Zhejiang 310000 (CN)
(72) Inventor: DENG, Shifeng, Hangzhou, Zhejiang 310000 (CN); SHI, Lei, Hangzhou, Zhejiang 310000 (CN)
(74) Representative: Gamba, Alessandro
(86) International application number: PCT/CN2023/101917
(87) International publication number: WO 2024/074055

(57) **Abstract**

Disclosed in the present disclosure is a connection structure for a battery and solder strips, the connection structure comprising a battery and a plurality of parallel solder strips placed on the battery, and further comprising a bonding mechanism arranged between the solder strips and the battery, wherein the bonding mechanism wraps the solder strips from outer sides and then bonds the solder strips to the battery, so as to fix the solder strips to the battery. The bonding mechanism fixes the solder strips to the battery from the outer sides of same, such that silver paste may be dispensed with, and an original connection between the solder strips and the silver paste is changed into a connection between the solder strips and the bonding mechanism, thereby dispensing with the silver paste and reducing the cost. A battery assembly comprises the above connection structure for the battery and the solder strips, the solder strips are provided on both an upper side and a lower side of the battery, and the battery assembly further comprises a front adhesive film layer arranged on the upper side of the battery, upper glass arranged on an upper side of the front adhesive film layer, a back adhesive film layer arranged on the lower side of the battery, and a cover plate arranged on a lower side of the back adhesive film layer. The front adhesive film layer and the back adhesive film layer are both used for lamination, so as to connect the battery assembly as a whole.

## Description

### CROSS-REFERENCE TO RELATED APPLICATION

The present invention claims the priority to the Chinese patent application with the filling No. 202211220767.6 filed with the Chinese Patent Office on October 8, 2022, and entitled "CONNECTION STRUCTURE FOR CELL AND INTERCONNECT WIRES, AND CELL ASSEMBLY COMPRISING CONNECTION STRUCTURE", the contents of which are incorporated herein by reference in entirety.

### TECHNICAL FIELD

The present disclosure relates to the field of connecting cells to interconnect wires, and particularly to a connection structure for cell (battery) and interconnect wires (solder strips), and a cell assembly comprising connection structure.

### BACKGROUND ART

In PV power generation, PV modules play the role of receiving sunlight and converting it into electrical energy. In practice, the cell is not a single piece but multiple pieces assembled together to ensure the output power of the assembly. The cell pieces are connected by interconnect wires, wherein a interconnect wire includes an inner copper substrate and an outer solder alloy layer. The solder alloy has a low melting point, which makes it easy to melt. However, neither the solder alloy nor the copper can connect well with the cell itself, resulting in low adhesion. Therefore, the usual practice is to apply silver paste, also known as a busbar, on the cell, and place the interconnect wire on the busbar. The solder alloy can fuse better with the busbar, which improves the bonding strength. However, there is also a problem here: silver paste is relatively expensive and accounts for a significant proportion of the cost of cell assemblies, which amounts to more than 20%. For enterprises, reducing costs while ensuring the efficiency of the power generation and the strength is a goal to pursue. Therefore, how to reduce the amount of silver paste while ensuring connection strength is an urgent problem that persons skilled in the art need to solve.

### SUMMARY

An objective of the present invention includes, for example, providing a connection structure for cell and interconnect wires and a cell assembly thereof to address at least the problems raised in the above background art.

In order to achieve the above objective, the embodiments of the present invention provide the following technical solutions. A connection structure for a cell and interconnect wires comprises a cell and multiple parallel interconnect wires placed on the cell, and further comprises a bonding mechanism arranged between the interconnect wires and the cell, wherein the bonding mechanism wraps the interconnect wires from outer sides and then bonds to the cell, so as to fix the interconnect wires to the cell. The connection structure for cell and interconnect wires further comprises a finger provided on the cell perpendicular to the interconnect wire. The end of the cell is provided with a reinforcing grid that is parallel to the finger. The reinforcing grid is located between two adjacent fingers and the reinforcing grid is located on the outer side of the outermost interconnect wire. The inner end of the reinforcing grid is connected to a connecting grid that is vertical, and both ends of the connecting grid are connected to the fingers on both sides of the reinforcing grid. The cell is provided with an auxiliary positioning grid for positioning the interconnect wire, wherein the auxiliary positioning grid is perpendicular to the finger, and the auxiliary positioning grid is located on the front surface or the back surface of the cell, and is provided only at a starting end of the interconnect wire. The finger can be configured to collect current on the cell. The number of fingers on the back surface of the cell is greater than that of fingers on the front surface. At least one surface of the front surface or the back surface is provided with the auxiliary positioning grid, and the auxiliary positioning grid is positioned at the starting end of the interconnect wire, without needing to be arranged in the middle. The reinforcing grid serves to facilitate the collection of current to the outermost interconnect wire and reduces resistance. The connecting grid prevents local breakage and facilitates current flow. Both the reinforcing grid and the connecting grid are made of silver paste.

The bonding mechanism secures the interconnect wire to the cell from the outside, thereby eliminating the silver paste and turning the original connection of the interconnect wire to the silver paste into a connection of the interconnect wire to the bonding mechanism, which saves the silver paste and reduces costs.

Optionally, the bonding mechanism can be a positioning adhesive tape, and the positioning adhesive tape wraps around the outside of the interconnect wire. Both sides of the positioning adhesive tape along the length direction can adhere to the cell.

Optionally, the positioning adhesive tape can be a hot-melt adhesive, high-performance pressure-sensitive adhesive, UV-catalyzed adhesive, or a PET substrate with high-performance pressure-sensitive adhesive coated on the end of the PET substrate near the interconnect wire, which has a good fixing effect.

Optionally, the positioning adhesive tape can be strip-shaped along the length direction of the interconnect wire. The number of the positioning adhesive tapes arranged along the length direction of the interconnect wire is the same as the number of the interconnect wires.

Optionally, the positioning adhesive tape can be strip-shaped and perpendicular to the interconnect wire, and the positioning adhesive tape can span across multiple parallel interconnect wires. The positioning adhesive tape can be perpendicular to the interconnect wire and span across the interconnect wire. One positioning adhesive tape can fix multiple interconnect wires, and multiple positioning adhesive tapes are arranged along the length direction of the interconnect wire.

Optionally, the positioning adhesive tape can be block-shaped, and multiple positioning adhesive tapes are arranged on each interconnect wire along the length direction. The positioning adhesive tape is square-shaped, multiple of which are arranged along the length direction of the interconnect wire, thus fixing the interconnect wire.

Optionally, the positioning adhesive tape can be in the form of a whole block covering all interconnect wires. The positioning adhesive tape can cover all interconnect wires, thus achieving complete coverage and increasing tensile strength. This prevents the adhesive film from flowing into the space between the interconnect wire and the adhesive film and causing product defects.

Optionally, the number of auxiliary positioning grids per row can be 15 to 35, and the auxiliary positioning grid has the width of 0.01 to 0.20 mm, and the height of 4 to 20 µm.

Optionally, both the front surface and the back surface of the cell can be provided with a interconnect wire and a finger.

Optionally, the interconnect wire can be a low-temperature interconnect wire. The base material in the middle of the low-temperature interconnect wire is copper and the outer side is solder alloy. The solder alloy includes, in addition to tin, at least one or more metals such as lead, bismuth, silver, or indium so as to lower the melting point. During lamination, it can be directly heated to fuse the interconnect wire with the finger, with the melting temperature ranging from 120°C to 160°C.

Optionally, the cell can be a thin-sheet cell, with a thickness range of 70 to 150 µm.

The embodiments of the present invention further provide a cell assembly, wherein the cell assembly comprises the connection structure for cell and interconnect wires above.

Optionally, the interconnect wires are provided on both an upper side and a lower side of the cell, and the cell assembly further comprises a front-surface adhesive film layer arranged on the upper side of the cell, upper glass arranged on an upper side of the front-surface adhesive film layer, a back-surface adhesive film layer arranged on the lower side of the cell, and a cover plate arranged on a lower side of the back-surface adhesive film layer. The front-surface adhesive film layer and the back-surface adhesive film layer are both used for lamination, so as to connect the cell assembly as a whole.

Optionally, the front-surface adhesive film layer and back-surface adhesive film layer can be made of POE (polyolefin elastomer), EVA (ethyl vinyl acetate), or EPE (expanded polyethylene).

Optionally, the cover plate can be glass or a back plate. Glass or back plate is available.

Compared to the prior art, the present invention is capable of achieving at least the following beneficial effects.

1. Compared to the original method of arranging silver paste on the cell for connection with the interconnect wire, the busbar is directly eliminated here, and the positioning adhesive tape is applied for connection and fixation. This ensures strength, reduces costs, and eliminates the need for flux, thereby reducing the risk of yellowing due to long-term outdoor aging of the flux and other materials.

2. Reinforcing grids are arranged at both ends of the finger to increase the capacity of current transmission.

3. At the inner end of the finger, a connecting grid is arranged to achieve the transmission of current to the finger; and the reinforcing grid facilitates current collection. In actual production, the interconnect wire can have a certain positional deviation and can move onto the reinforcing grid or be located at the inner side of the reinforcing grid, thus detaching from the reinforcing grid. However, in the event of local breakage, the part where the reinforcing grid and connecting grid are connected will continue to transmit the current through the reinforcing grid to the finger, thus facilitating current transmission and ensuring current collection inside the breakage region.

4. High-temperature infrared welding is eliminated, and low-temperature interconnection processes enable the interconnection of thin-sheet cells, thus reducing the amount of crystalline silicon used.

5. Only one reinforcing grid is arranged between two fingers to achieve current balancing; and the outer side has twice the transmission distance of that of the inner side of the interconnect wire. Therefore, arranging one reinforcing grid between the fingers ensures current balancing and eliminates the defect of light and dark sheets.

### BRIEF DESCRIPTION OF DRAWINGS

FIG. 1 shows a schematic diagram of a connection between a cell and a reinforcing grid in the present invention;
FIG. 2 shows a structural schematic diagram of the cell and a interconnect wire in the embodiments of the present invention;
FIG. 3 shows a sectional view of the cell and the interconnect wire in another embodiment of the present invention;
FIG. 4 shows a structural schematic diagram of the cell and the interconnect wire in another embodiment of the present invention;
FIG. 5 shows a structural schematic diagram of the cell and the interconnect wire in another embodiment of the present invention;
FIG. 6 shows a structural schematic diagram of the cell and the interconnect wire in another embodiment of the present invention;
FIG. 7 shows a sectional view of a cell assembly in the present invention;
FIG. 8 shows a tensile force diagram of the ordinary interconnect wire combined with the busbar after welding;
FIG. 9 shows a tensile force diagram after the tape secures the cell in the present invention; and
FIG. 10 shows a plan view of a cell assembly according to the embodiment of the present invention.

In the drawings: 1- cell; 11- interconnect wire; 12- finger; 13- auxiliary positioning grid; 14- reinforcing grid; 15- connecting grid; 2- positioning adhesive tape; 3- front-surface adhesive film layer; 31- upper glass; 32- back-surface adhesive film layer; 33- cover plate.

### DETAILED DESCRIPTION OF EMBODIMENTS

Below will be a clear and complete description of the technical solution in the embodiments of the present invention, in conjunction with the drawings of the embodiments of the present invention. Obviously, the described embodiments are only part of the embodiments of the present invention, not all embodiments. Based on the embodiments of the present invention, all other embodiments obtained by those skilled in the art without inventive effort shall fall within the protection scope of the present invention.

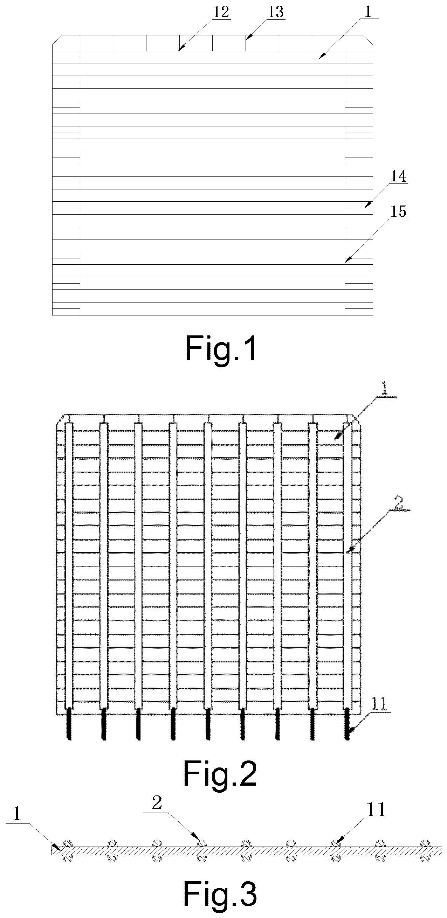

Referring to FIG. 1, the embodiment of the present invention provides a technical solution for a connection structure for cell and interconnect wires, and a cell assembly thereof. The connection structure for cell and interconnect wires can comprise a cell 1 and multiple parallel interconnect wires 11 arranged on the cell 1, and can also comprise a bonding mechanism provided between the interconnect wires 11 and the cell 1. The bonding mechanism can wrap the interconnect wires 11 from outer sides and then bond to the cell 1, so as to fix the interconnect wires 11 to the cell 1. The bonding mechanism secures the interconnect wire 11 to the cell 1 from the out sides, thereby eliminating the silver paste and turning the original connection of the interconnect wire to the silver paste into a connection of the interconnect wire to the bonding mechanism. This reduces costs. The connection structure for cell and interconnect wires further can comprise a finger 12 provided on the cell 1 perpendicular to the interconnect wire 11. The finger 12 can be configured to collect current on the cell 1. The number of fingers 12 on the back surface of the cell 1 can be greater than the number of fingers 12 on the front surface. The cell 1 can be provided with an auxiliary positioning grid 13 for positioning the interconnect wire 11, wherein the auxiliary positioning grid 13 can be perpendicular to the finger 12, and the auxiliary positioning grid 13 can be located on the front surface or the back surface of the cell 1. At least one surface of the front surface or the back surface is needed, and the auxiliary positioning grid is positioned at the starting end of the interconnect wire 11, without needing to be arranged in the middle. In the present invention, only one end of the interconnect wire 11 is positioned with the auxiliary positioning grid 13. Since positioning is only performed at one end, the positioning end itself needs to be exposed (not considered as exposure), and there is no positioning at the other end. This avoids the phenomenon of exposure, caused by the misalignment of the interconnect wire 11, in the part of the auxiliary positioning grid 13 between two cells, thereby improving the yield rate. The number of auxiliary positioning grids 13 per row can be 15 to 35, the width of the auxiliary positioning grid 13 can be 0.01 to 0.20 mm, and a height can be 4 to 20 µm. The end portion of the cell 1 can be provided with a reinforcing grid 14 that is parallel to the finger 12. The reinforcing grid 14 can be located between two adjacent fingers 12 and the reinforcing grid 14 can be located on the outer side of the outermost interconnect wire 11. The inner end of the reinforcing grid 14 can be connected to a connecting grid 15 that is vertical, and both ends of the connecting grid 15 can be connected to the fingers 12 on both sides of the reinforcing grid 14. The reinforcing grid 14 serves to facilitate the collection of current to the outermost interconnect wire 11 and reduces resistance. The connecting grid 15 prevents local breakage and facilitates current flow. Both the reinforcing grid 14 and the connecting grid 15 can be made of silver paste. Both the front surface and the back surface of the cell 1 can be provided with a interconnect wire 11 and a finger 12.

The interconnect wire 11 can be a low-temperature interconnect wire, wherein the base material in the middle of the low-temperature interconnect wire is copper and the outer side is solder alloy. The solder alloy includes, in addition to tin, at least one or more metals such as lead, bismuth, silver, or indium so as to lower the melting point. During lamination, it can be directly heated to fuse the interconnect wire 11 with the finger 12, with the melting temperature ranging from 120°C to 160°C. The cell 1 can be a thin-sheet cell with a thickness range of 70 to 150 µm.

Referring to FIGS. 2 to 3, the embodiment of the present invention provides a technical solution for a connection structure for cell and interconnect wires, and a cell assembly thereof. The connection structure for cell and interconnect wires comprises a cell 1 and multiple parallel interconnect wires 11 arranged on the cell 1, and can also comprise a bonding mechanism provided between the interconnect wires 11 and the cell 1. The bonding mechanism wraps the interconnect wires 11 from outer sides and then bonds to the cell 1, so as to fix the interconnect wires 11 to the cell 1. The bonding mechanism can secure the interconnect wire 11 to the cell 1 from the outside, thereby eliminating the silver paste and turning the original connection of the interconnect wire to the silver paste into a connection of the interconnect wire to the bonding mechanism. This saves the silver paste and reduces costs. The bonding mechanism can be a positioning adhesive tape 2, and the positioning adhesive tape 2 wraps around the outside of the interconnect wire 11. Both sides of the positioning adhesive tape 2 along the length direction can adhere to the cell 1. The positioning adhesive tape 2 can be a hot-melt adhesive, high-performance pressure-sensitive adhesive, UV-catalyzed adhesive, or a PET substrate with high-performance pressure-sensitive adhesive coated on the end of the PET substrate near the interconnect wire 11, which has a good fixing effect.

The interconnect wire 11 can be a low-temperature interconnect wire, wherein the base material in the middle of the low-temperature interconnect wire is copper and the outer side is solder alloy. The solder alloy includes, in addition to tin, at least one or more metals such as lead, bismuth, silver, or indium so as to lower the melting point. During lamination, it can be directly heated to fuse the interconnect wire 11 with the finger 12, with the melting temperature ranging from 120°C to 160°C. The cell 1 can be a thin-sheet cell with a thickness range of 70 to 150 µm.

The positioning adhesive tape 2 can be strip-shaped along the length direction of the interconnect wire 11. The number of the positioning adhesive tapes 2 arranged along the length direction of the interconnect wire 11 is the same as the number of the interconnect wires 11.

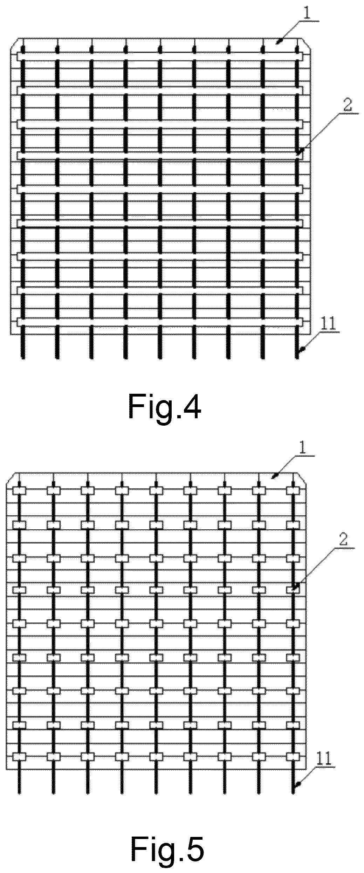

Referring to FIG. 4, the embodiment of the present invention provides a technical solution for a connection structure for cell and interconnect wires, and a cell assembly thereof. The connection structure for cell and interconnect wires comprises a cell 1 and multiple parallel interconnect wires 11 arranged on the cell 1, and can also comprise a bonding mechanism provided between the interconnect wires 11 and the cell 1. The bonding mechanism can wrap the interconnect wires 11 from outer sides and then bond to the cell 1, so as to fix the interconnect wires 11 to the cell 1. The bonding mechanism can secure the interconnect wire 11 to the cell 1 from the outside, thereby eliminating the silver paste and turning the original connection of the interconnect wire to the silver paste into a connection of the interconnect wire to the bonding mechanism. This saves the silver paste and reduces costs. The bonding mechanism can be a positioning adhesive tape 2, and the positioning adhesive tape 2 wraps around the outside of the interconnect wire 11. Both sides of the positioning adhesive tape 2 along the length direction adhere to the cell 1. The positioning adhesive tape 2 can be a hot-melt adhesive, high-performance pressure-sensitive adhesive, UV-catalyzed adhesive, or a PET substrate with high-performance pressure-sensitive adhesive coated on the end of the PET substrate near the interconnect wire 11, which has a good fixing effect.

The interconnect wire 11 can be a low-temperature interconnect wire, wherein the base material in the middle of the low-temperature interconnect wire can be copper and the outer side can be solder alloy. The solder alloy includes, in addition to tin, at least one or more metals such as lead, bismuth, silver, or indium so as to lower the melting point. During lamination, it can be directly heated to fuse the interconnect wire 11 with the finger 12, with the melting temperature ranging from 120°C to 160°C. The cell 1 is a thin-sheet cell with a thickness range of 70 to 150 µm.

The positioning adhesive tape 2 can be strip-shaped and perpendicular to the interconnect wire 11 and the positioning adhesive tape 2 can span across multiple parallel interconnect wires 11. The positioning adhesive tape 2 can be perpendicular to the interconnect wire 11 and can span across the interconnect wire 11. One positioning adhesive tape 2 can fix multiple interconnect wires 11, and multiple positioning adhesive tapes 2 are arranged along the length direction of the interconnect wire 11.

Referring to FIG. 5, the embodiment of the present invention provides a technical solution for a connection structure for cell and interconnect wires, and a cell assembly thereof. The connection structure for cell and interconnect wires comprises a cell 1 and multiple parallel interconnect wires 11 arranged on the cell 1, and can also comprise a bonding mechanism provided between the interconnect wires 11 and the cell 1. The bonding mechanism can wrap the interconnect wires 11 from outer sides and then bond to the cell 1, so as to fix the interconnect wires 11 to the cell 1. The bonding mechanism can secure the interconnect wire 11 to the cell 1 from the outside, thereby eliminating the silver paste and turning the original connection of the interconnect wire to the silver paste into a connection of the interconnect wire to the bonding mechanism. This saves silver paste and reduces costs. The bonding mechanism can be a positioning adhesive tape 2, and the positioning adhesive tape 2 can wrap around the outside of the interconnect wire 11. Both sides of the positioning adhesive tape 2 along the length direction can adhere to the cell 1. The positioning adhesive tape 2 can be a hot-melt adhesive, high-performance pressure-sensitive adhesive, UV-catalyzed adhesive, or a PET substrate with high-performance pressure-sensitive adhesive coated on the end of the PET substrate near the interconnect wire 11, which has a good fixing effect.

The interconnect wire 11 can be a low-temperature interconnect wire, wherein the base material in the middle of the low-temperature interconnect wire can be copper and the outer side can be solder alloy. The solder alloy can include, in addition to tin, at least one or more metals such as lead, bismuth, silver, or indium so as to lower the melting point. During lamination, it can be directly heated to fuse the interconnect wire 11 with the finger 12, with the melting temperature ranging from 120°C to 160°C. The cell 1 is a thin-sheet cell with a thickness range of 70 to 150 µm.

The positioning adhesive tape 2 can be block-shaped, and multiple positioning adhesive tapes 2 are arranged on each interconnect wire 11 along the length direction. The positioning adhesive tape 2 is square-shaped, multiple of which are arranged along the length direction of the interconnect wire 11, thus fixing the interconnect wire.

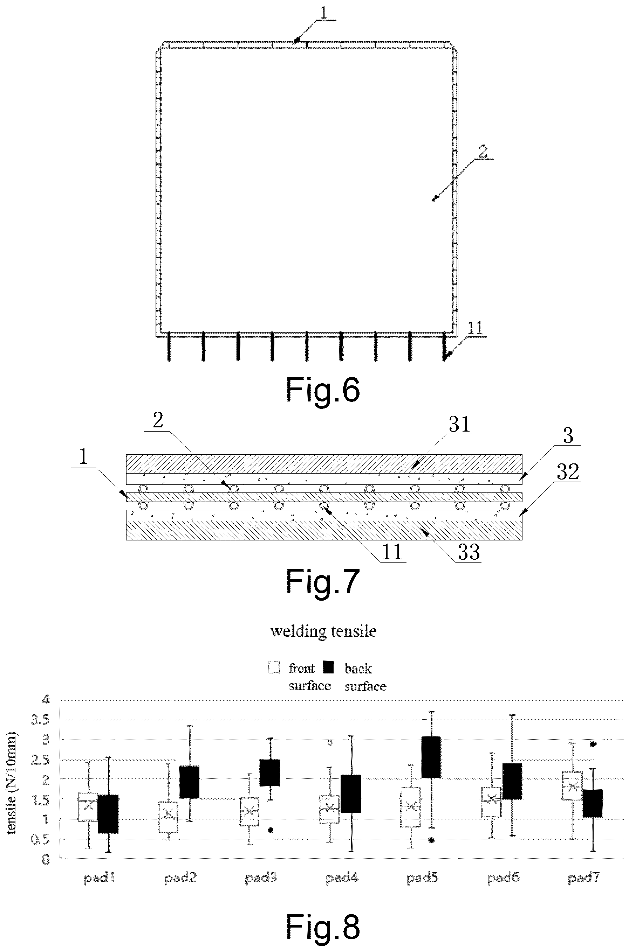

Referring to FIG. 6, the embodiment of the present invention provides a technical solution for a connection structure for cell and interconnect wires, and a cell assembly thereof. The connection structure for cell and interconnect wires comprises a cell 1 and multiple parallel interconnect wires 11 arranged on the cell 1, and can also comprise a bonding mechanism provided between the interconnect wires 11 and the cell 1. The bonding mechanism can wrap the interconnect wires 11 from outer sides and then bond to the cell 1, so as to fix the interconnect wires 11 to the cell 1. The bonding mechanism can secure the interconnect wire 11 to the cell 1 from the outside, thereby eliminating the silver paste and turning the original connection of the interconnect wire to the silver paste into a connection of the interconnect wire to the bonding mechanism. This saves the silver paste and reduces costs. The bonding mechanism can be a positioning adhesive tape 2, and the positioning adhesive tape 2 can wrap around the outside of the interconnect wire 11. Both sides of the positioning adhesive tape 2 along the length direction can adhere to the cell 1. The positioning adhesive tape 2 can be a hot-melt adhesive, high-performance pressure-sensitive adhesive, UV-catalyzed adhesive, or a PET substrate with high-performance pressure-sensitive adhesive coated on the end of the PET substrate near the interconnect wire 11, which has a good fixing effect.

The interconnect wire 11 can be a low-temperature interconnect wire, wherein the base material in the middle of the low-temperature interconnect wire can be copper and the outer side can be solder alloy. The solder alloy can include, in addition to tin, at least one or more metals such as lead, bismuth, silver, or indium so as to lower the melting point. During lamination, it can be directly heated to fuse the interconnect wire 11 with the finger 12, with the melting temperature ranging from 120°C to 160°C. The cell 1 can be a thin-sheet cell with a thickness range of 70 to 150 µm.

The positioning adhesive tape 2 can be in the form of a whole block covering all interconnect wires 11. The positioning adhesive tape 2 can cover all interconnect wires 11, thus achieving complete coverage and increasing tensile strength. This prevents the adhesive film from flowing into the space between the interconnect wire and the adhesive film and causing product defects.

Referring to FIG. 7, the embodiment of the present invention further provides a cell assembly, comprising the connection structure for cell and interconnect wires above. The interconnect wires 11 are provided on both an upper side and a lower side of the cell 1, and the cell assembly further comprises a front-surface adhesive film layer 3 arranged on the upper side of the cell 1, the upper glass 31 arranged on an upper side of the front-surface adhesive film layer 3, a back-surface adhesive film layer 32 arranged on the lower side of the cell 1, and a cover plate 33 arranged on a lower side of the back-surface adhesive film layer 32. The front-surface adhesive film layer 3 and the back-surface adhesive film layer 32 are both configured for lamination, so as to connect the cell assembly as a whole. The front-surface adhesive film layer 3 and the back-surface adhesive film layer 32 can be made of POE, EVA, or EPE. Optionally, the cover plate 33 can be glass or a back plate. Glass or back plate is available.

The working principle is as follows. Compared to the original method of arranging silver paste on the cell 1 for connection with the interconnect wire 11, the busbar is directly eliminated here, and the positioning adhesive tape 2 is applied for connection and fixation. This ensures strength and reduces costs, thereby reducing the risk of yellowing due to long-term outdoor aging of the flux and other materials. The reinforcing grids 14 are arranged at both ends of the finger 12 to increase the capacity of current transmission. At the end portion of the finger 12, a connecting grid 15 is arranged, which can transmit current to the finger 12 in the event of local breakage, thus facilitating current transmission.

### Test 1

A 180° tensile test was conducted using a tensile machine.

For ordinary busbars combined with the interconnect wires, pad represents the solder pad point, and the welding tensile test after welding is shown in FIG. 8.

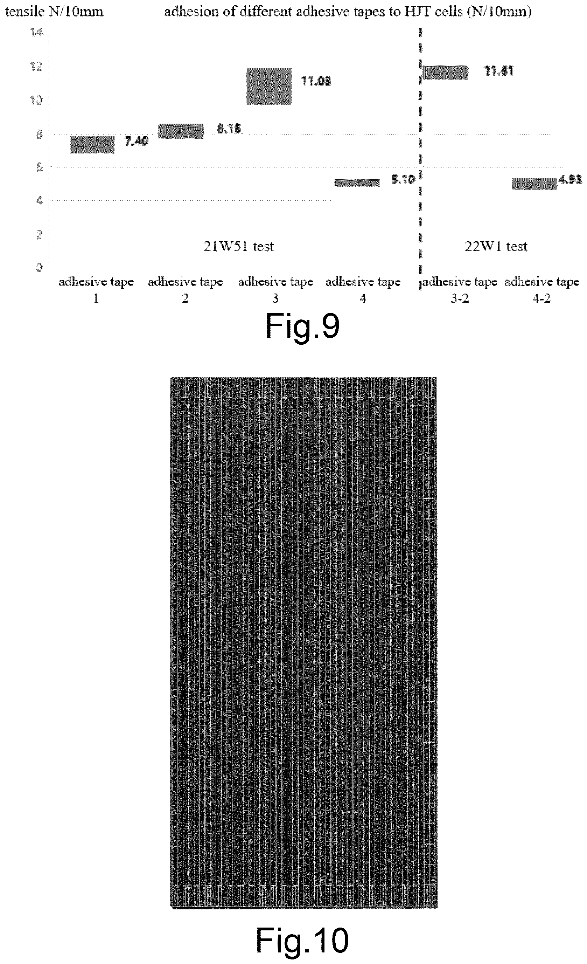

For the cell fixed with the positioning adhesive tape, the results obtained through multiple samplings are shown in FIG. 9.

From the above comparison, it can be seen that the tensile strength produced by the positioning adhesive tape is generally greater than the strength of the interconnect wire and busbar that are directly connected. This means that compared to the original connection of the interconnect wire and the silver paste, the connection strength between the positioning adhesive tape and the cell is higher. Thus, while reducing costs, the strength is increased.

### Test 2

For the connection of the interconnect wire and the busbar, under the same cell and lighting environment, the power was measured as follows (test conditions: 1000W/m2, 25°C).

| technology | interconnect wire diameter /mm | number of interconnect wires /pcs | Pmax (W) | Voc (V) | Isc (A) | Rs (Ω) | FF (%) | Im (A) | Vm (V) |
|---|---|---|---|---|---|---|---|---|---|
| prior art | 0.35 | 12 | 659.15 | 49.303 | 17.30 | 0.2509 | 77.29 | 16.51 | 39.93 |
| after optimization | 0.20 | 25 | 669.54 | 49.312 | 17.26 | 0.2081 | 78.66 | 16.50 | 40.57 |

Through the comparison in the above figures, it is found that compared to the existing connection of the interconnect wire and the busbar, the tested power increases from 659.15 W to 669.54 W in the connection of the positioning adhesive tape and the interconnect wire, where the losses are reduced and the voltage is increased without compounding of the busbar and silver paste. With the increase in the number of interconnect wires, the transmission distance from the finger to the interconnect wire decreases, and the resistance is lowered, thus increasing the module power.

In summary of Test 1 and Test 2, compared to the original connection of the interconnect wire and the busbar, the connection using positioning adhesive tape and interconnect wire reduces the amount of silver paste. Additionally, both tensile strength and power increase, achieving three benefits in one approach.

Although embodiments of the present invention have been illustrated and described, it is understood that those ordinarily skilled in the art can make various changes, modifications, substitutions, and variations to these embodiments without departing from the principles and spirit of the present invention. The scope of the present invention is defined by the appended claims and their equivalents.

### Industrial Practicality

The embodiments of present invention provide a connection structure for cell and interconnect wires, and a cell assembly thereof. Compared to the original method of arranging silver paste on the cell for connection with the interconnect wire, the busbar is directly eliminated here, and the positioning adhesive tape is applied for connection and fixation. This ensures strength, reduces costs, and eliminates the need for flux, thereby reducing the risk of yellowing due to long-term outdoor aging of the flux and other materials. The reinforcing grids are arranged at both ends of the finger to increase the capacity of current transmission. At the end portion of the finger, a connecting grid is arranged, which can transmit current to the finger in the event of local breakage, thus facilitating current transmission. High-temperature infrared welding is eliminated, and low-temperature interconnection processes enable the interconnection of thin-sheet cells, thus reducing the amount of crystalline silicon used.

Additionally, it is important to note that the connection structure for cell and interconnect wires, and the cell assembly thereof provided in the embodiments of the present invention are reproducible and applicable in various industrial applications. For example, the connection structure for cell and interconnect wires, and the cell assembly thereof provided in the embodiments of the present invention can be used in technical fields relating to the connection of cells to interconnect wires, such as the field of connection structures of cells and interconnect wires and cell assemblies thereof.

## Claims

1. A connection structure for cell and interconnect wires, comprising a cell (1) and multiple parallel interconnect wires (11) arranged on the cell (1), **characterized by** further comprising a bonding mechanism provided between the interconnect wires (11) and the cell (1); the bonding mechanism wraps the interconnect wires (11) from outer sides and then bonds to the cell (1), so as to fix the interconnect wires (11) to the cell (1); and the connection structure for cell and interconnect wires further comprises fingers (12) provided on the cell (1) perpendicular to the interconnect wires (11), wherein an end portion of the cell (1) is provided with a reinforcing grid (14) that is parallel to the fingers (12); the reinforcing grid (14) is located between two adjacent fingers (12) and the reinforcing grid (14) is located on an outer side of an outermost interconnect wire (11); an inner end of the reinforcing grid (14) is connected to a connecting grid (15) that is vertical, and both ends of the connecting grid (15) are connected to the fingers (12) on both sides of the reinforcing grid (14); and the cell (1) is provided with an auxiliary positioning grid (13) for positioning the interconnect wires (11), wherein the auxiliary positioning grid (13) is perpendicular to the fingers (12), and the auxiliary positioning grid (13) is located on a front surface or a back surface of the cell (1) and is provided only at a starting end of the interconnect wires (11).

2. The connection structure for cell and interconnect wires according to claim 1, wherein the bonding mechanism is a positioning adhesive tape (2), and the positioning adhesive tape (2) wraps around an outside of the interconnect wires (11); and both sides of the positioning adhesive tape (2) along a length direction adhere to the cell (1).

3. The connection structure for cell and interconnect wires according to claim 2, wherein the positioning adhesive tape (2) is a hot-melt adhesive, a high-performance pressure-sensitive adhesive, a UV-catalyzed adhesive, or a PET substrate with the high-performance pressure-sensitive adhesive coated on an end of the PET substrate near the interconnect wires (11).

4. The connection structure for cell and interconnect wires according to claim 2 or 3, wherein the positioning adhesive tape (2) is strip-shaped along a length direction of the interconnect wires (11).

5. The connection structure for cell and interconnect wires according to claim 2 or 3, wherein the positioning adhesive tape (2) is strip-shaped and perpendicular to the interconnect wires (11), and the positioning adhesive tape (2) spans across multiple parallel interconnect wires (11).

6. The connection structure for cell and interconnect wires according to claim 2 or 3, wherein the positioning adhesive tape (2) is block-shaped, and multiple positioning adhesive tapes (2) are arranged on each interconnect wire (11) along the length direction.

7. The connection structure for cell and interconnect wires according to claim 2 or 3, wherein the positioning adhesive tape (2) is in a form of a whole block covering all interconnect wires (11).

8. The connection structure for cell and interconnect wires according to any one of claims 1 to 7, wherein a number of auxiliary positioning grids (13) per row is 15 to 35, and the auxiliary positioning grid (13) has a width of 0.01 to 0.20 mm, and a height of 4 to 20 µm.

9. The connection structure for cell and interconnect wires according to any one of claims 1 to 8, wherein both the front surface and the back surface of the cell (1) are provided with the interconnect wires (11) and the fingers (12).

10. The connection structure for cell and interconnect wires according to any one of claims 1 to 9, wherein the interconnect wires (11) are of a low-temperature interconnect wire.

11. The connection structure for cell and interconnect wires according to any one of claims 1 to 10, wherein the cell (1) is a thin-sheet cell, with a thickness range of 70 to 150 µm.

12. The connection structure for cell and interconnect wires according to claim 10, wherein a base material in a middle of the low-temperature interconnect wire is copper and an outer side of the low-temperature interconnect wire is a solder alloy; and the solder alloy comprises, in addition to tin, at least one or more of lead, bismuth, silver and indium.

13. The connection structure for cell and interconnect wires according to any one of claims 1 to 12, wherein during lamination with direct heating, the interconnect wires (11) and the fingers (12) are melted and thus fused together at a temperature of 120°C to 160°C.

14. A cell assembly, **characterized by** comprising the connection structure for cell and interconnect wires according to any one of claims 1 to 13.

15. The cell assembly according to claim 14, wherein the interconnect wires (11) are provided on both an upper side and a lower side of the cell (1), and the cell assembly further comprises a front-surface adhesive film layer (3) arranged on the upper side of the cell (1), an upper glass (31) arranged on an upper side of the front-surface adhesive film layer (3), a back-surface adhesive film layer (32) arranged on the lower side of the cell (1), and a cover plate (33) arranged on a lower side of the back-surface adhesive film layer (32).

16. The cell assembly according to claim 15, wherein the front-surface adhesive film layer (3) and the back-surface adhesive film layer (32) can be made of POE, EVA, or EPE.

17. The cell assembly according to claim 15 or 16, wherein the cover plate (33) can be glass or a back plate.
